Europäisches Patentamt

European Patent Office

Office européen des brevets

(19)

(11) Numéro de publication: **0 317 038**
**A1**

## (12) DEMANDE DE BREVET EUROPEEN

(21) Numéro de dépôt: 88202608.1

(22) Date de dépôt: 21.11.88

(51) Int. Cl.4: **H01L 23/04 , H01L 23/48**

(30) Priorité: 20.11.87 FR 8716089

(43) Date de publication de la demande:
24.05.89 Bulletin 89/21

(84) Etats contractants désignés:
**DE FR GB NL**

(71) Demandeur: **Laboratoires d'Electronique et de Physique Appliquée L.E.P.**
**3, Avenue Descartes**
**F-94450 Limeil-Brévannes(FR)**

(84) **FR**

(71) Demandeur: **N.V. Philips' Gloeilampenfabrieken**
**Groenewoudseweg 1**
**NL-5621 BA Eindhoven(NL)**

(84) **DE GB NL**

(72) Inventeur: **Binet, Michel**
**Société Civile S.P.I.D. 209 Rue de l'Université**
**F-75007 Paris(FR)**
Inventeur: **Meignant, Didier**
**Société Civile S.P.I.D. 209 Rue de l'Université**
**F-75007 Paris(FR)**

(74) Mandataire: **Pinchon, Pierre et al**
**Société Civile S.P.I.D. 209 rue de l'Université**
**F-75007 Paris(FR)**

(54) **Boîtier sans broches pourvu d'un circuit intégré numérique ultrarapide.**

(57) L'invention concerne un boîtier pour un circuit intégré (101) comprenant un socle (102) muni d'un évidement (103) pour recevoir le circuit (101) et de plots de contact (13) auxquels les plots du circuit (101) doivent être connectés. Le boîtier comprend en outre un dispositif de connexion qui inclut un substrat (100) muni sur sa face supérieure d'une pluralité de lignes de connexion (10). Le substrat (100) est inséré dans l'évidement (103) du socle (102) et est muni d'une ouverture centrale (50) pour recevoir le circuit intégré (101). Les lignes de connexion (10) ne présentent pratiquement aucune inductances parasites et peuvent être connectées au circuit (101) par une de leurs extrêmités .et aux plots de contact (13) par leur autre extrémité au moyen de fils métalliques très courts (1, 2) fisés par exemple par thermocompression.

FIG. 1

## BOITIER SANS BROCHES POURVU D'UN CIRCUIT INTEGRE NUMERIQUE ULTRARAPIDE

L'invention concerne un boîtier incluant un socle muni d'un évidement pour recevoir un circuit intégré et muni de plots de contact disposés à la périphérie de l'évidement.

L'invention trouve son application dans le domaine des circuits intégrés numériques ultra-rapides réalisés par exemple en arséniure de gallium et commercialisés après montage dans un boîtier standard.

A ce jour, les circuits intégrés en arséniure de gallium commencent à prendre un grand développement industriel. Les circuits numériques réalisés sur arséniure de gallium présentent notamment la propriété d'être ultra-rapides. Mais pour être commercialisés, ces circuits doivent être montés dans un boîtier. Or il n'existe pas vraiment actuellement de boîtier adapté à recevoir ce genre de circuit.

On connaît un boîtier fabriqué par la firme TEKTRONIX sous la référence P/N 812-0012-00, mais ce boîtier présente d'abord un trop petit nombre de broches utilisables, en l'occurrence huit broches, pour être adapté à recevoir les circuits numériques. Les circuits numériques montrent un grand nombre d'entrées-sorties, nécessitant en conséquence un grand nombre de broches, par exemple 10 à 60 broches. Le boîtier connu convient seulement pour les circuits analogiques qui se suffisent de moins de 10 broches. De plus le boîtier TEKTRONIX est très coûteux et présente des dimensions très grandes, dû au fait qu'il est réalisé en technologie coplanaire c'est-à-dire qu'une ligne sur deux doit être une ligne de masse.

En effet, le problème technique posé par la réalisation d'un boîtier pour circuit intégré numérique ultra-rapide réside dans les faits que :
- ce boîtier ne doit pas présenter de capacités parasites,
- ce boîtier ne doit pas présenter d'inductances parasites,
- ce boîtier doit présenter entre 10 et 60 broches.

On connaît aussi un boîtier commercialisé par exemple par la firme NARUMI sous la référence MCB-51524 A. Ce boîtier connu répond à deux des trois conditions :
- il est muni de plots de contact au lieu de broches, ce qui élimine les inductances parasites,
- il a suffisamment de plots pour être utilisé pour le montage de circuits numériques actuellement en fabrication.

Cependant, ce boîtier connu présente encore des inconvénients pour l'application envisagée. Du fait de l'écartement fixe des plots à 1,27 mm les uns des autres, répartis sur la périphérie du boîtier, ce dernier montre pour un nombre de plots donné, une surface interne qui est grande par rapport à la surface du substrat du circuit intégré. Par exemple, un tel boîtier, apte à recevoir un circuit à 24 entrées-sorties, a pour dimensions externes 10 x 10 mm, et pour dimensions de l'évidement interne réservé au substrat du circuit intégré 6 x 6 mm, alors que ce même substrat a seulement entre 1,5 et 2,5 mm de côté. Le substrat du circuit intégré doit donc être fixé au centre de l'évidement à environ 2 mm des plots du boîtier et en conséquence des fils de câblage d'au moins 2 mm de long sont nécessaires pour réaliser la connexion entre les plots du circuit intégré sur le substrat et les plots du boîtier. Ces fils représentent alors une inductance parasite de 2 nH, ce qui détériore les performances du circuit.

Un objet de la présente invention est de fournir un boîtier dans lequel une connexion entre les plots du circuit intégré et les plots de contact du boîtier peut être ob tenue telle que les inductances parasites introduites sont pratiquement nulles.

Selon la présente invention, un boîtier tel que décrit dans le préambule est caractérisé en ce qu'il comprend en outre un dispositif de connexion inséré dans l'évidement du socle, dispositif de connexion muni d'une ouverture en son centre pour recevoir le circuit intégré, et sur la face supérieure duquel sont disposées des lignes de connexion s'étendant du bord de l'ouverture à la périphérie dudit dispositif.

Du fait de la présence du dispositif de connexion dans l'évidement du socle, la longueur des fils de câblage qui assurent la connexion entre les plots du circuit intégré et les plots de contact du socle, peut être beaucoup plus petite. On obtient en conséquence une réduction considérable des inductances parasites, tout en conservant la possibilité d'utiliser un socle standard. Les lignes de connexion sur la surface supérieure sont réalisées de préférence au moyen d'une technologie dite microruban comprenant au moins une couche métallique appliquée par sérigraphie.

Les entrées du circuit intégré numérique se font souvent sur les grilles de transistors à effet de champ qui ont des impédances élevées. Or pour raccorder un circuit intégré à un autre circuit intégré, on utilise plutôt des connexions d'impédance 50 Ω. Il en résulte qu'il serait hautement souhaitable pour une telle application que le dispositif de connexion comprenne des premières lignes de connexion qui aient une impédance de l'ordre de 50Ω. On comprendra que ces premières lignes de connexions sont très appropriées à la connexion des entrées/sorties du circuit intégré. Il serait en outre très souhaitable pour une telle application, que des résistances de 50 Ω soient insérées entre les plots du cicuit intégré et la masse pour éviter les réflexions. Le boîtier connu ne permet pas ce branchement. C'est pourquoi dans une réalisation préférentielle, le boîtier selon l'invention est caractérisé en ce que le dispositif de connexion comprend des résistances de l'ordre de 50Ω pour être connectées entre les dites premières lignes de connexion et la masse. Les résistances de 50Ω peuvent être facilement disposées sur le substrat entre les lignes de connexion, sans nécessiter une augmentation de la surface. Certains des plots du boîtier doivent aussi recevoir les alimentations continues du circuit intégré. Or il est souhaitable que ces alimentations se fassent à très basse impédance, sinon les variations du courant d'alimentation entraîneraient des variations des tensions continues d'alimentation, et donc une dégradation des performances des circuits. Il est donc nécessaire que les alimentations soient découplées par des capacités situées le plus près possible du circuit, de préférence à l'intérieur du boîtier, ce qui n'est pas possible avec le boîtier connu.

C'est pourquoi, dans une autre réalisation préférentielle le boîtier selon l'invention est caractérisé en ce que le dispositif de connexion comprend des capacités et desdites secondes lignes de connexion qui sont découplées par lesdites capacités. Les secondes lignes de connexion peuvent avantageusement être utilisées comme lignes d'alimentation continue.

L'invention sera mieux comprise à l'aide de la description suivante illustrée par les figures annexées dont :

- la figure 1 qui représente schématiquement en coupe un boîtier selon l'invention associé à une pastille de circuit intégré ;

- la figure 2 qui représente schématiquement vu du dessus le dispositif de connexion du boîtier de la figure 1 ;

- les figures 3a à 3c qui représentent schématiquement en coupe le dispositif de connexion de la figure 2 ;

- la figure 4 qui représente schématiquement vu du dessus un socle standard.

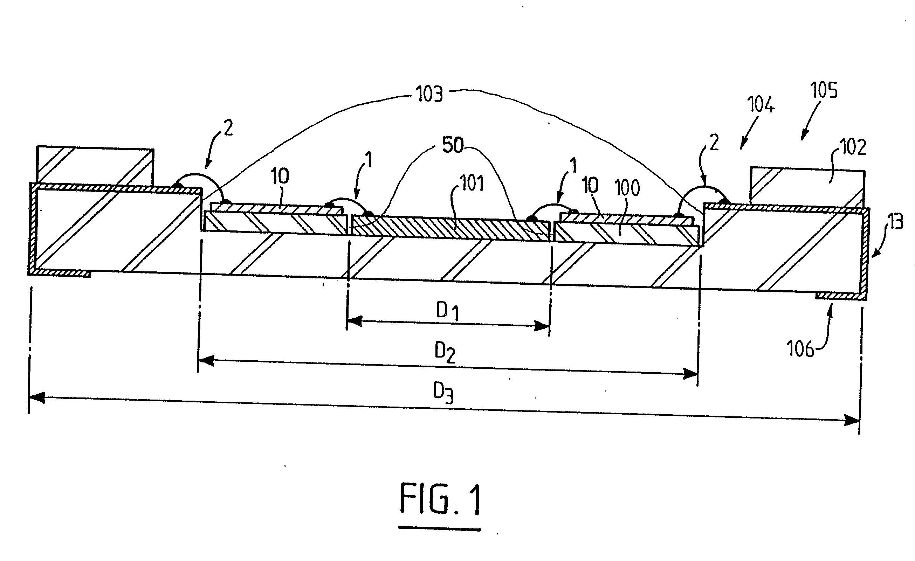

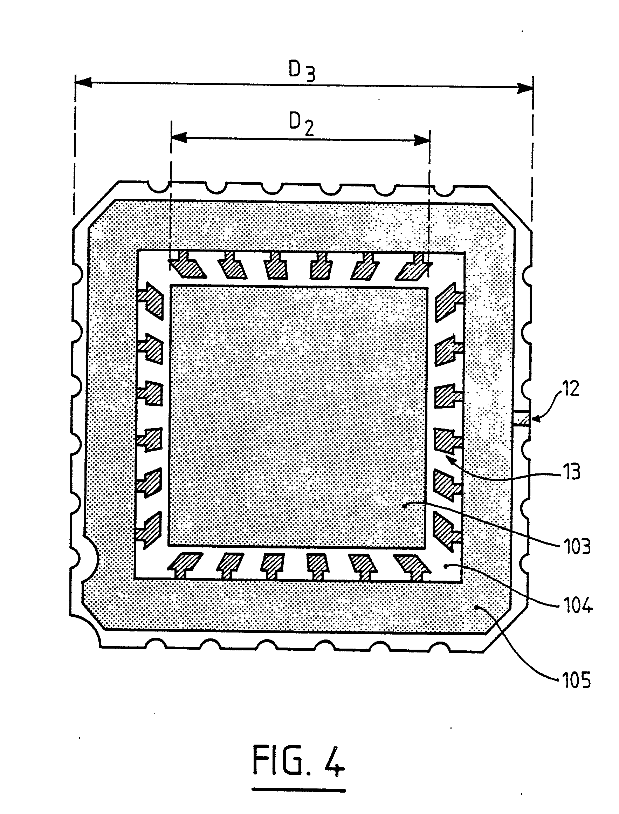

La figure 1 représente donc en coupe un boîtier selon l'invention incluant un socle standard 102 sans broches, de dimensions extérieures $D_3$. Ce socle 102, lorsqu'il est considéré vu du dessus, comme sur la figure 4, est carré, et de surface totale $D_3 \times D_3$. Il représente en son centre un évidement 103 qui est aussi carré, de surface $D_2 \times D_2$. Il présente en outre un décrochement 104 sur lequel se trouvent des plots métalliques 13 régulièrement espacés autour de l'évidement 103, avec un pas d'environ 1,27 mm. Les plots de contact se prolongent pour apparaître sur la partie inférieure du socle. Un autre décrochement 105 protège les plots.

Le socle 102 existe dans le commerce en plusieurs modèles, présentant plus ou moins de plots, dont les dimensions $D_2$ et $D_3$ sont d'autant plus grandes que le nombre de plots est plus élevé.

Dans cet exemple de réalisation, nous nous intéresserons à un socle à 24 plots qui présente les dimensions :
$D_3 = 10$ mm,
$D_2 = 6$ mm.
Ce socle est destiné à recevoir une pastille de circuit intégré numérique 101 (voir figure 1) par exemple carré dont les dimensions sont :
$D_1 \simeq 2$ mm.

Si le circuit intégré 101 devait être connecté aux plots de contact 13 du socle 102, des fils de câblage d'environ 2 mm devraient être utilisés. De tels fils représenteraient une inductance parasite d'environ 2nH.

Le but de l'invention est de fournir un boîtier pour un circuit intégré 101 dans lequel la connexion entre les plots du circuit intégré 101, et les plots 13 du socle 102, peut être obtenue tout en évitant, ou au moins en réduisant considérablement ces industances parasites.

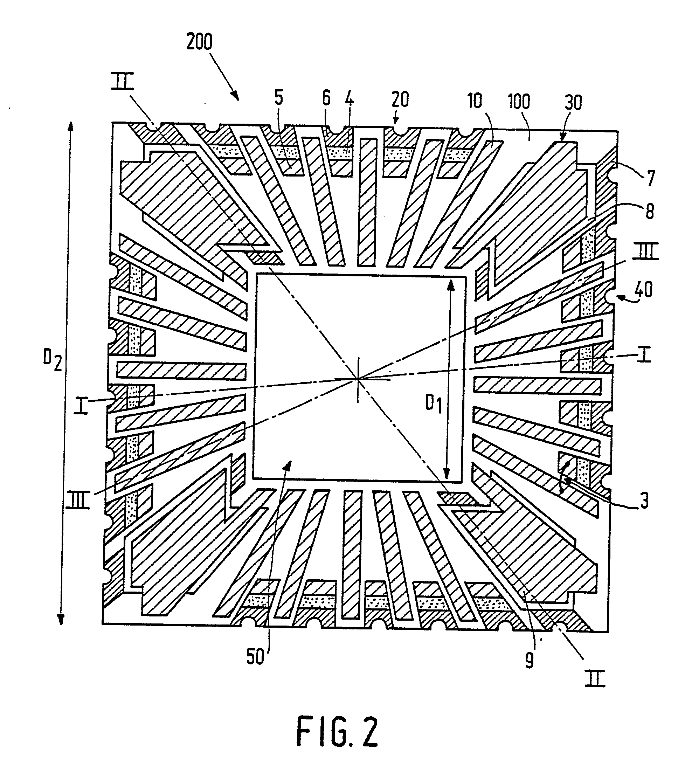

Selon l'invention, ce but est atteint au moyen d'un boîtier qui comprend un dispositif de connexion 200 disposé dans l'évidement 103 du socle 102, dispositif de connexion dont la face supérieure est munie d'une pluralité de lignes 10, 30 (voir figures 1 et 2). Le dispositif de connexion 200 présente suffisamment de lignes de connexion 10, 30 pour connecter tous les plots du circuit intégré. Les lignes 10, 30 sont formées au moyen de la technologie dite microruban par au moins une couche métallique appliquée par sérigraphie sur un substrat diélectrique très mince 100, qui dans le présent exemple est un substrat carré en alumine ($Al_2O_3$) d'épaisseur
$e \simeq 0,25$ mm.
Le substrat 100 présente des dimensions légèrement inférieures à $D_2$ de manière à pouvoir être inséré dans l'évidement interne 103 du socle 102, dans une position où sa surface inférieure repose sur le fond de l'évidement 103.

Le dispositif de connexion 200 comprend un évidement central 50, de dimensions très légèrement supérieures à celles de la pastille de circuit intégré 101, c'est-à-dire très légèrement supérieures à $D_1$ pour pouvoir recevoir cette pastille de circuit intégré.

Les lignes de connexion 10 et 30 s'étendent radialement des bords de l'évidement 50 à la périphérie du substrat 100.

Mais il est évident que lorsqu'un socle 102 présentant des dimensions $D_2$ et $D_3$ supérieures

pour un plus grand nombre de plots de contact 13 est utilisé, et lorsque le circuit intégré 101 présente des dimensions $D_1$ différentes ou bien lorsque le circuit intégré 101 n'est pas carré, la dimension externe $D_2$ du dispositif de connexion 200 et la dimension $D_1$ de son évidement 50 varient en conséquence.

Le dispositif de connexion 200 présentera alors un nombre de lignes de connexion 10 et 30 en conséquence du nombre de plots utilisés sur le socle 102.

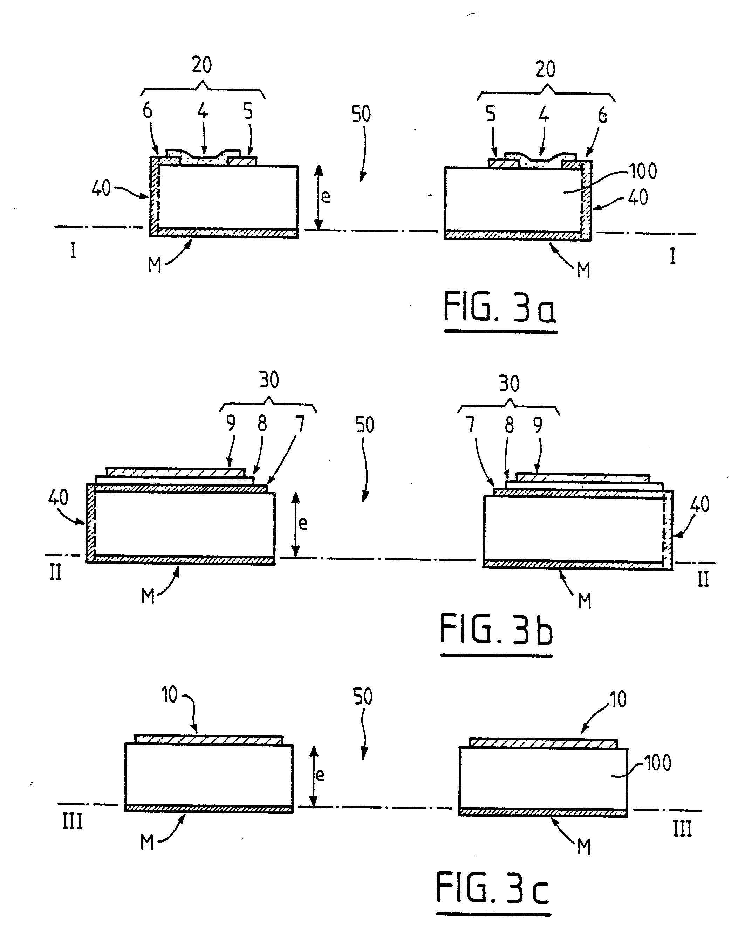

Le substrat 100 comprend d'abord une couche métallique M couvrant entièrement une de ses faces, dite face inférieure, comme il est montré en coupe sur les figures 3. Cette couche M sert de plan de masse, et de radiateur thermique.

Dans cette réalisation préférentielle, le dispositif de connexion 200, comprend, parmi les lignes 10 et 30, desdites premières lignes 10 qui ont une impédance de pratiquement 50Ω. Ces lignes sont particulièrement appropriées à l'interconnexion de circuits intégrés entre eux, que l'on réalise généralement au moyen de connexions ayant une impédance de 50Ω. Les réflexions peuvent être évitées si l'on utilise lesdites premières lignes de connexion 10 à cet effet.

La figure 3c montre une coupe schématique du dispositif 200, selon l'axe III-III de la figure 2. Cette coupe montre une disposition de couches formant les premières lignes de connexion 10. Les premières lignes de connexion 10 sont formées au moyen d'une simple couche métallique en forme de ruban. La largeur de ces lignes transversalement est prévue de la même dimension que l'épaisseur e du substrat 100.

Il est en outre souhaitable lorsque l'on interconnecte les circuits intégrés, d'insérer des résistances de 50Ω entre les plots du circuit intégré et la masse. Dans ce but, le dispositif de connexion 200 comprend en outre les résistances 20 qui ont une valeur de pratiquement 50Ω.

La figure 3a est une coupe du dispositif 200, selon l'axe I-I de la figure 2 montrant les résistances 20. Ces résistances sont constituées d'une couche d'un matériau résistif 4 formant la partie centrale de la résistance et, de part et d'autre de cette partie centrale, de couches métalliques 5 et 6 formant les extrémités conductrices de la résistance.

Une des extrémités 5 est destinée à être reliée à une première ligne de connexion de 50 Ω si nécessaire. L'autre extrémité 6 est reliée au plan de masse M par un demi-trou métallisé 40 pratiqué dans l'épaisseur e du substrat. Les couches 4, 5, 6 sont réalisées par sérigraphie. La couche 6 est formée de manière à être connectée à la couche de masse M de la face inférieure. La couche 4 est réalisée de préférence recouvrant partiellement les couches 5 et 6. La surface de la couche résistive 4 qui ne recouvre pas 5 et 6, détermine la valeur de la résistance 20. Cette surface est prévue pour réaliser une résistance de pratiquement 50Ω. Il sera favorable de réaliser les résistances 20 dans les espaces situés entre chaque ligne de connexion 10, 30, car cela ne nécessite pas de surface additionnelle. De plus dans ce cas, quand cela est nécessaire une première ligne de connexion 10 et une résistance adjacente 20 peuvent être reliées par un fil très court 3 fixé par thermocompression. D'autre part, parmi les lignes de connexion, on a aussi lesdites secondes lignes de connexion 30 qui sont découplées par des capacités. Ces lignes de connexion 30 sont tout à fait appropriées à être utilisées comme lignes d'alimentation continues pour le circuit intégré. Il est souhaitable que ces lignes présentent une très basse impédance pour éviter que les variations du courant d'alimentation entraînent des variations de la tension continue d'alimentation et par là une dégradation des performances du circuit 101. C'est pourquoi, il est nécessaire de découpler les lignes d'alimentation du circuit intégré 101 par des capacités disposées aussi près que possible du circuit 101, de préférence à l'intérieur du boîtier. Cela n'est pas possible avec le boîtier connu de l'état de la technique, alors que le boîtier selon l'invention permet la réalisation d'un tel découplage des lignes d'alimentation, au moyen desdites secondes lignes de connexion 30.

La figure 3b est une coupe schématique du dispositif selon l'axe II-II. Cette coupe montre une disposition de couches formant les secondes lignes d'alimentation découplée 30. Ces lignes sont formées :
- d'une première couche métallique 7, formant la première électrode d'une capacité et reliée au plan de masse M par un demi-trou métallisé 40 ;
- d'une couche 8 en un matériau diélectrique à fort coefficient diélectrique ε qui couvre partiellement la première couche métallique 7 ;
- et d'une seconde couche métallique 9, qui forme la seconde électrode de la capacité et est disposée sur la face supérieure de la couche diélectrique 8. C'est cette seconde couche métallique 9 qui sera raccordée au plot d'alimentation continue du circuit intégré 101 et au plot d'alimentation continue du socle 102. La valeur de la capacité 7, 8, 9 est déterminée par la proportion du recouvrement des surfaces des deux couches métalliques qui est choisie pour obtenir les valeurs voulues de cette capacité.

Il sera favorable de réaliser les lignes d'alimentation et leur capacité de découplage 7, 8, 9 selon les diagonales du substrat 100, dans le but de disposer d'une surface suffisante à obtenir la valeur de la capacité désirée.

Lorsque le dispositif de connexion 200 et le circuit intégré 101 sont mis en place dans le socle 102, les pre mières lignes de connexion 10 sont reliées par une extrémité au plot d'entrée-sortie du circuit intégré 101 par des fils très courts 1 soudés par thermocompression, et sont reliées par l'autre extrémité au plot 13 du socle par des fils très courts 2 soudés de même (voir figure 1).

De même les secondes lignes de connexion sont reliées d'une part au plot d'alimentation du circuit intégré 101 et d'autre part au plot de contact correspondant du socle par les fils très courts.

Comme il a été mentionné auparavant, le dispositif de connexion 200 sera réalisé de préférence par sérigraphie au moyen d'encre conductrice ou bien résistive ou diélectrique selon les parties de ce circuit. On obtiendra ainsi des lignes du type dit microruban, différant du type coplanaire par le fait qu'il n'est pas nécessaire d'intercaler une ligne de masse entre chaque ligne. Il se fait ainsi un gain appréciable de surface, tout en maintenant un haut niveau de qualité du circuit en hyperfréquences.

**Revendications**

1. Boîtier incluant un socle muni d'un évidement pour recevoir un circuit intégré et muni de plots de contact disposés à la périphérie de l'évidement, caractérisé en ce qu'il comprend en outre un dispositif de connexion inséré dans l'évidement du socle, dispositif de connexion muni d'une ouverture en son centre pour recevoir le circuit intégré, et sur la face supérieure duquel sont disposées des lignes de connexion s'étendant du bord de l'ouverture à la périphérie dudit dispositif.

2. Boîtier selon la revendication 1 caractérisé en ce que la face inférieure du dispositif de connexion est munie d'une couche métallique formant plan de masse.

3. Boîtier selon l'une des revendications 1 ou 2 caractérisé en ce que le dispositif de connexion comprend desdites premières lignes de connexion dont l'impédance est de l'ordre de 50Ω.

4. Boîtier selon la revendication 3, caractérisé en ce que lesdites premières lignes de connexion comprennent un ruban métallique formé sur un substrat diélectrique, ruban dont la largeur est pratiquement égale à l'épaisseur du substrat.

5. Boîtier selon l'une des revendications 2, 3 ou 4, caractérisé en ce que le dispositif de connexion comprend des résistances de l'ordre de 50Ω pour être connectées entre lesdites premières lignes de connexion et la masse.

6. Boîtier selon la revendication 5, caractérisé en ce que les résistances comprennent chacune une couche résistive munie de contacts à chaque extrêmité, l'un des contacts étant relié à la terre et l'autre à une première ligne de connexion.

7. Boîtier selon l'une des revendications 5 ou 6, caractérisé en ce qu'une première ligne de connexion est connectée à l'un des contacts d'une résistance adjacente au moyen d'un fil métallique très court, par exemple fixé par thermocompression.

8. Boîtier selon l'une des revendications précédentes, caractérisé en ce que le dispositif de connexion comprend des capacités et desdites secondes lignes de connexion qui sont découplées par lesdites capacités.

9. Boîtier selon la revendication 8, caractérisé en ce qu'une dite seconde ligne de connesion comprend une première couche métallique et une seconde couche métallique qui sont séparées l'une de l'autre par une couche diélectrique et qui constituent respectivement une première et une seconde électrode de la capacité, la première électrode étant reliée à la terre.

10 Boîtier selon l'une des revendications 8 ou 9 caractérisé en ce que le dispositif de connexion est quadrangulaire et en ce que les secondes lignes de connexion sont disposées selon des diagonales.

11. Boîtier selon l'une des revendications 2 à 9, caractérisé en ce que la connexion entre une ligne de connexion et la terre est obtenue au moyen d'un trou métallisé ou d'un demi-trou métallisé.

12. Boîtier selon l'une quelconque des revendications précédentes caractérisé en ce que les lignes de connexion sont connectées au circuit intégré par une de leurs extrémités et aux plots de contact du socle par leur seconde extrémité, au moyen de fils métalliques courts, fixés par exemple par thermocompression.

13. Dispositif de connexion pour être utilisé dans un boîtier selon l'une quelconque des revendications précédentes.

FIG. 1

EP 0 317 038 A1

1-IV-PHF 87−588

FIG. 2

FIG. 3a

FIG. 3b

FIG. 3c

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 564 244 (GIGABIT LOGIC)<br>* page 1, ligne 1 - page 6, ligne 10; figure 1 *<br>--- | 1,3,5-13 | H 01 L 23/04<br>H 01 L 23/48 |
| A | WO-A-8 401 470 (MAYO FOUNDATION)<br>* page 15, ligne 23 - page 31, ligne 32; figures 1-4,17-24 *<br>--- | 1,3,5-13 | |
| A | EP-A-0 228 953 (CIMSA SINTRA)<br>* colonne 2, ligne 40 - colonne 4, ligne 16; figures 1a, b *<br>--- | 1-13 | |
| A | EP-A-0 072 644 (AMP INC.)<br>* page 3, ligne 34 - page 5, ligne 12; figures 1-3 *<br>----- | 1,3 | |

DOMAINES TECHNIQUES RECHERCHES (Int. Cl.4)

H 01 L 23/00

Le présent rapport a été établi pour toutes les revendications

| Lieu de la recherche | Date d'achèvement de la recherche | Examinateur |
|---|---|---|
| BERLIN | 03-02-1989 | ROUSSEL A T |